# EUROPEAN PATENT APPLICATION

(11) **EP 0 837 499 A1**
(43) Date of publication of application: **22.04.1998**
(21) Application number: 97118055.9
(22) Date of filing: 17.10.1997
(51) Int. Cl.: H01L 21/66, H01L 21/8242, H01L 27/108

(54) **Semiconductor DRAM device having monitor element for monitoring capacitance**

(30) Priority: 21.10.1996 JP 277749/96
(71) Applicant: NEC CORPORATION, Tokyo (JP)
(72) Inventor: Hirota, Toshiyuki, Minato-ku, Tokyo (JP); Okamura, Kenji, Minato-ku, Tokyo (JP)
(74) Representative: Betten & Resch

(57) **Abstract**

A DRAM having a capacitor with a hemispherical silicon grain (HSG) type lower electrode is provided with a monitor element to accurately evaluate the capacitive dielectric film, and to evaluate the increment of the surface area of the lower electrode due to its roughened structure. The surface of the lower electrode of the capacitor is formed in a roughened structure in a memory section of a semiconductor chip while a capacitor having a lower electrode with a smooth shape is formed on a monitor element section of the semiconductor chip.

## Description

### BACKGROUND OF THE INVENTION

The present invention relates to a semiconductor device and a method for manufacturing the same. More particularly, it relates to a semiconductor device that has a monitor element for monitoring a capacitor element whose surface is made uneven, and further to a method of producing it.

Among semiconductor memory devices, there is a DRAM in which storage information can be arbitrarily read and written. Each memory cell for the DRAM is in general composed of one transfer transistor and one capacitor. In order to enhance memory capacity, each cell is formed with a small size. Such cell is, however, required to maintain a certain capacitance value.

For this purpose, a three-dimensional structure has been developed and used as a capacitor for each memory cell. The three-dimensional structure makes the surface area of the capacitor electrode large with a reduced area of occupation.

A stack structure is widely used for the capacitor with three-dimensional structure for the DRAM memory cell. A capacitor with stack structure has high resistance against incidence of alpha rays and noise from circuits, and stably operates even when it has a relatively low capacity value. Thus, it is believed that the capacitor with stack structure (hereinafter called the "stack capacitor") is effective even for a 4 giga-bit DRAM for which the design rule of a semiconductor element is about 0.12 µm.

In addition, in order to further increase the effective surface area of the capacitor electrode, it is proposed to provide a fin stack capacitor, a cylinder stack capacitor, or a stack capacitor with the hemispherical silicon grain technology (called hereinafter an "HSG type").

When such stack capacitors are arranged in the memory section of a semiconductor device, it becomes particularly important to monitor its finish. In an HSG type, particularly, how much its surface area increases is significantly affected by its manufacturing conditions, it becomes necessary to check measurement and evaluation of the capacitor in the manufacturing process of the semiconductor device.

An example of such measurement and evaluation check for the capacitance is described in Japanese Laid-Open Patent Publication (Kokai) Hei 5-102264. In this case, the capacitor is formed on a test chip together with the transfer transistor. In addition, a monitor capacitor for the measurement and evaluation check is also formed in the same semiconductor chip as the semiconductor device.

Now, referring to FIGS. 4 and 5, there is described formation of a conventional monitor capacitor. Here, FIG. 7 is a plan view of a semiconductor chip, while FIG. 8 is a sectional view of a capacitor and a monitor capacitor in the semiconductor chip.

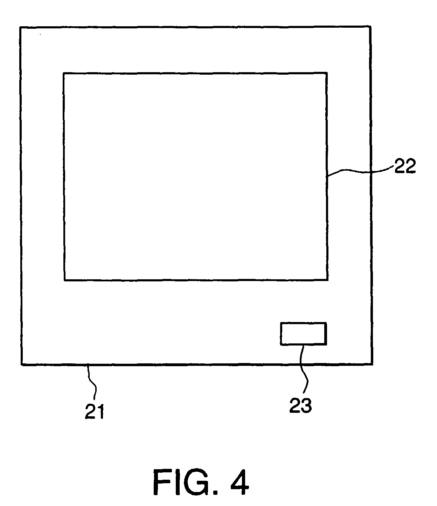

As shown in FIG. 4, a number of memory cells are arranged in a memory section 22 of a semiconductor chip 21. For example, it is assumed that such memory cells constitute a DRAM of a semiconductor device. Then, a capacitor for a monitor memory cell is formed in a monitor element section 23 located in a region around the semiconductor chip 21.

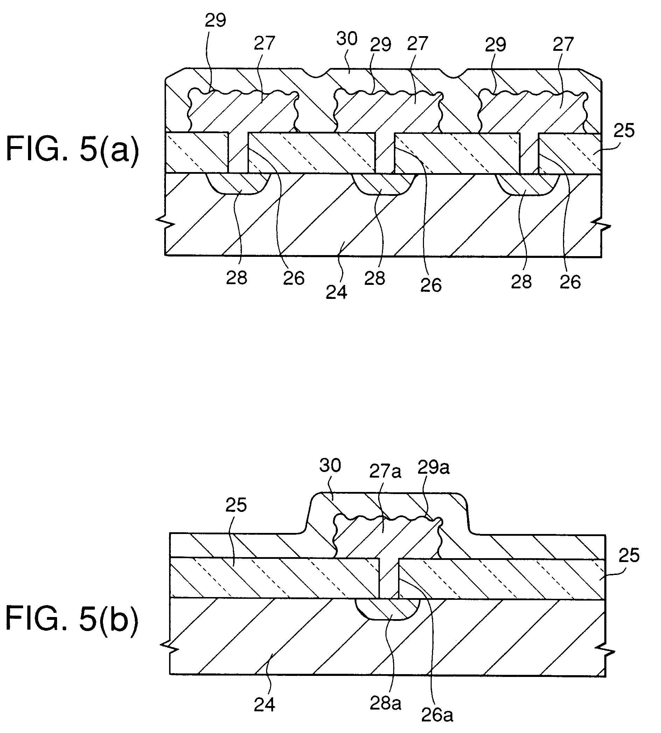

Now, description is given on the sectional structure of the memory section 22 and the monitor element section 23. FIG. 5 (a) is a schematic sectional view of a part of the memory section, and only shows capacitors for clarity In addition, FIG. 5 (b) is a schematic sectional view of one capacitor at the monitor element section.

As shown in FIG. 5 (a), an inter-layer insulating film 25 is formed on a surface of a silicon substrate 24 of P-type. Capacitor contact holes 26 are formed in predetermined locations of the inter-layer insulating film 25 and HSG type lower electrodes 27 for storing information are then formed. Each HSG type lower electrode 27 is made of polysilicon and contains N-type impurities. The N-type impurities are then introduced into the surface of the silicon substrate 24 through the capacitor contact holes 26. Thus, a capacitor diffusion layer 28 is formed.

Then, a capacitive dielectric film 29 is formed on the roughened surface of the HSG type lower electrode 27. An upper electrode 30 is provided to coat the capacitive dielectric film 29. Thus, a large number of capacitors are arranged on the memory section of the semiconductor device.

Similarly, as shown in FIG. 5 (b), the monitor element section is also formed with capacitors with the same shape as the capacitor on the memory section. Here, the capacitors formed on this region is in a small number. The figure shows a case of one.

As shown in FIG. 5 (b), as in the memory section, an inter-layer insulating film 25 is formed on the surface of the silicon substrate 24. Then, a capacitor contact hole 26a is formed in a predetermined region of the inter-layer dielectric film 25 to form one HSG type lower electrode 27a. Then, one capacitor diffusion layer 28a is formed.

Then, as in the capacitor on the memory section, a capacitive dielectric film 29a is formed on the roughened surface of the HSG type lower electrode 27a. In addition, an upper electrode 30 is formed to coat the capacitive dielectric film 29a. Thus, one capacitor is formed on the monitor element section.

As described above, the conventional technology forms the capacitors with the same shape on the memory section and the monitor element section of the semiconductor chip.

In such semiconductor chip, the capacity value of the capacitor on the monitor element section is measured and evaluated after completion of the semiconductor device, or after the upper electrode of the capacitor completes. Then, increment of the surface area of the HSG type lower electrode is evaluated from the measurement of capacity value.

However, the capacity value of capacitor depends on the contribution of the surface area of the lower electrode, the film thickness of the capacitive dielectric film, and the contribution of dielectric constant. To evaluate increment of the surface area of lower electrode from the capacity value, it becomes necessary to evaluate the film thickness of the capacitive dielectric film by another method. As this method, it is usual to monitor the film thickness in the process for forming the capacitive dielectric film. However, this is a physical evaluation method such as measurement of film thickness of the capacitive dielectric film, and not an electrical evaluation method such as measurement of the capacity value of the capacitor. Thus, in a case of a dielectric film formed by laminating capacitive dielectric films, for example, a silicon nitride/silicon oxide (NO) film, it becomes difficult to evaluate contribution of the capacity value of the capacitive dielectric film.

In the conventional technology described above, the lower electrode of the capacitor on the monitor element section becomes the same HSG type as the lower electrode of the capacitor on the memory section. Thus, it is impossible to evaluate increase of the surface area of the HSG type lower electrode only with the capacity value of the capacitor on the memory section.

This makes it difficult in the manufacturing process of semiconductor device to control monitoring of the shape of the HSG type lower electrode or the capacitive dielectric film, whereby it makes it difficult to control the reliability and the production yield of the semiconductor device. Such problem becomes significant when the semiconductor element is reduced in its size so that the semiconductor device is highly integrated and densified.

### SUMMARY OF THE INVENTION

An object of the present invention is to provide a semiconductor device and a method of producing it, which makes it easy to accurately evaluate the capacitive dielectric film, and increase of the surface area of the lower electrode.

A semiconductor device according to the present invention comprises a memory section and a monitor element section, the memory and monitor element sections being on a semiconductor chip on which the semiconductor device is mounted, the surface of a lower electrode of a capacitor being formed in a roughened structure on the capacitor section, at least a lower electrode of the capacitor being formed in a smooth structure on the monitor element section.

Here, the roughened structure is of a semi-spherical silicon structure.

In addition, a manufacturing process for the semiconductor device of the present invention comprises the steps of forming a patterned semiconductor thin film on a memory section and a monitor element section on which the semiconductor device is mounted; providing a process for preventing formation of a roughened structure on the semiconductor thin film formed on the monitor element section; and roughening the patterned semiconductor thin film.

Here, the roughened structure becomes a semi-spherical silicon structure.

Then, the process for preventing the roughened structure is to use a method for irradiating a laser beam or electron beam onto the semiconductor thin film.

### BRIEF DESCRIPTION OF THE DRAWINGS

This above-mentioned and other objects, features and advantages of this invention will become more apparent by reference to the following detailed description of the invention taken in conjunction with the accompanying drawings, wherein:

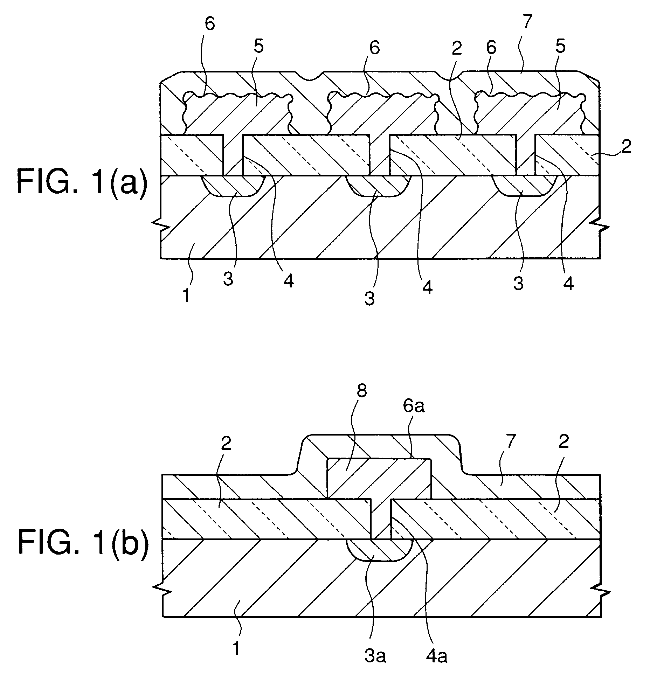

FIGS. 1(a) and 1(b) are sectional views of respective parts of a memory cell array section and a monitor element section according to a first embodiment of the present invention;

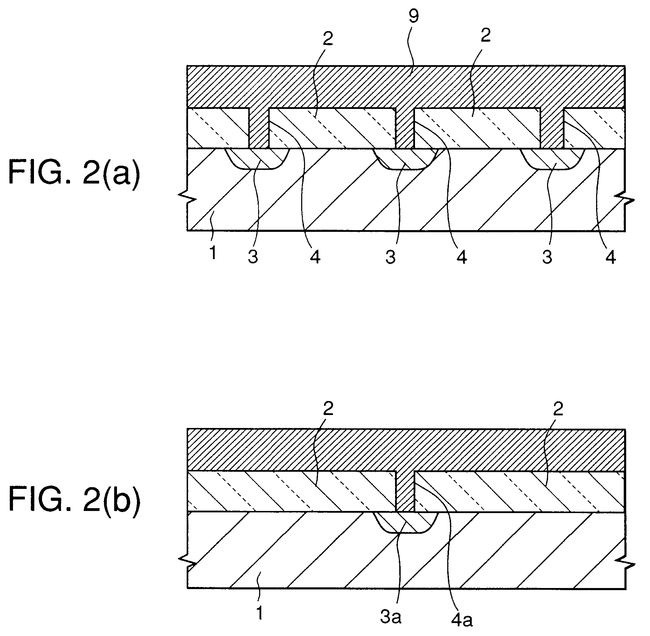

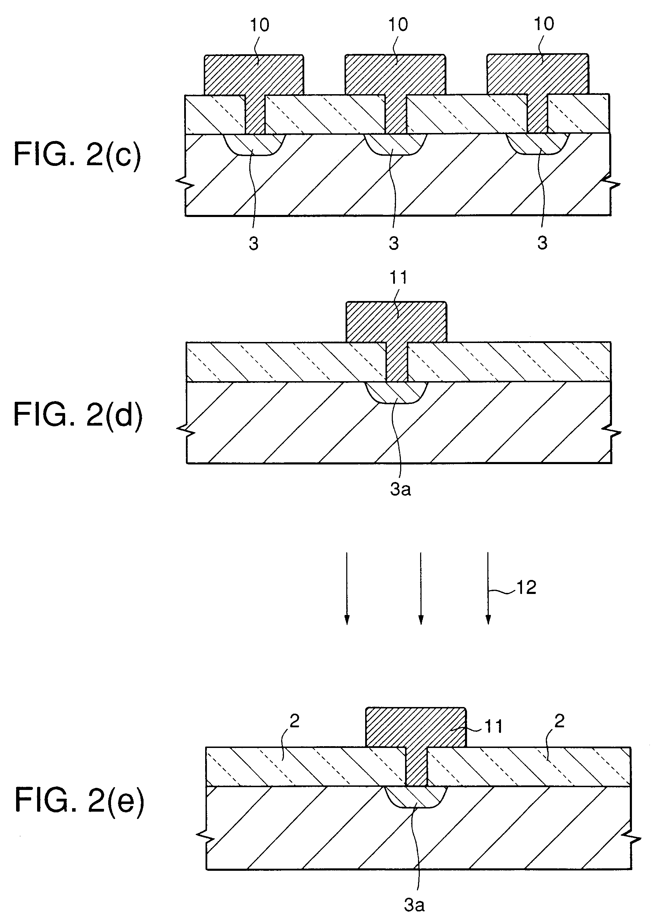

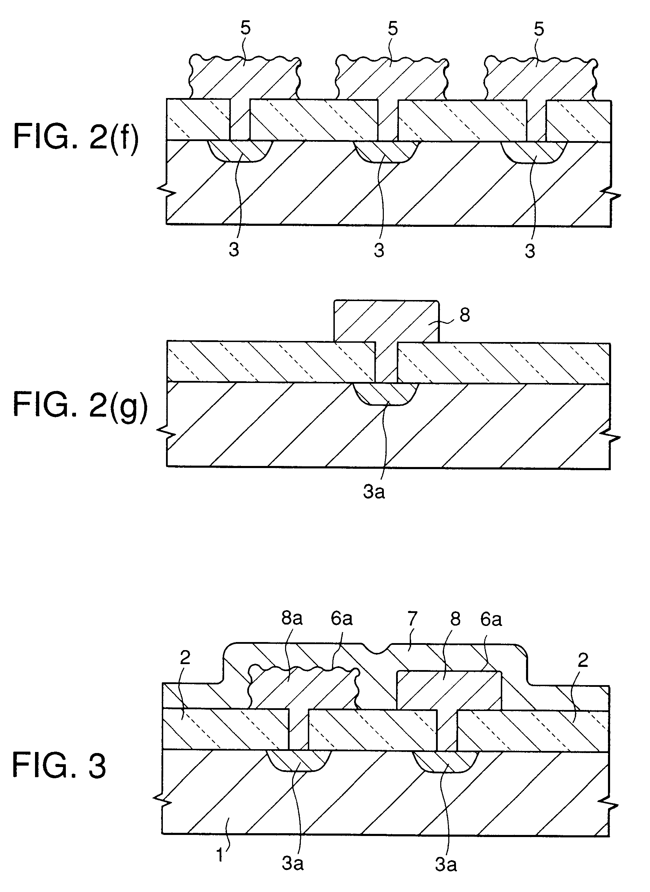

FIGS. 2(a) to 2(g) are sectional views illustrative of respective steps of producing a device of FIG. 1;
FIG. 3 is a sectional view of a part of a monitor element section according to a second embodiment of the present invention;
FIG. 4 is a plan view of a semiconductor chip; and
FIGS. 5(a) and 5(b) are sectional views of respective parts of a memory cell section and a monitor element section according to the prior art.

### DETAILED DESCRIPTION OF THE PREFERRED EMBODIMENTS

Now, a first embodiment of the present invention will be explained with reference to FIG. 1. Here, FIG. 1(a) is a sectional view of the capacitors at a memory section 22 (FIG. 4) and FIG. 1(b) is a sectional view of a part of monitor element section 23 (FIG. 4). As described with reference to FIG. 4, the semiconductor chip has the memory and the monitor element sections of the semiconductor device. Then, a sectional structure is described for a part of the memory section and the monitor element section.

As shown in FIG. 1(a), an inter-layer insulating film 2 is formed on a surface of the silicon substrate 1 of a P-type and capacitor diffusing layers or regions 3 are selectively provided in the surface portion of the silicon substrate 1. In addition, capacitor contact holes 4 are formed in predetermined regions of the inter-layer insulating film 2, in which HSG type lower or storage electrodes 5 are formed for storing information. Each HSG type lower electrode 5 is made of silicon or polysilicon and contains N-type impurities such as phosphorus or arsenic. Then, a capacitive dielectric film 6 is formed on the roughened surface of the HSG type lower electrode 5. An upper or plate electrode 7 is provided on the capacitive dielectric film 6. Thus, a large number of capacitors are arranged in the memory section of the semiconductor device.

This device further includes a monitor capacitor formed on the monitor element section in accordance with the present invention, as shown in FIG. 1(b). More specifically, the inter-layer insulating film 2 is formed on the surface of the silicon substrate 1, and a capacitor diffusion layer or region 3a is selectively formed. A capacitor contact hole 4a is formed in a predetermined region of the inter-layer insulating film 2 to form one monitor lower or storage electrode 8. Note that the surface of the monitor lower electrode 8 is not roughened, but is smooth, in accordance with the present invention.

In addition, a capacitive dielectric film 6a is formed on the surface of the monitor lower electrode 8. Furthermore, an upper or plate electrode 7 is provided on the capacitive dielectric film 6a. Thus, one capacitor is formed on the monitor element section.

Now, description is given on a manufacturing process for the semiconductor device described for the first embodiment of the present invention with reference to FIGS. 2(a) through 2(g). It should be noted that FIGS. 2(a), 2(c) and 2(f) are sectional views of the capacitors in the memory section, while FIGS. 2(b), 2(d), 2(e) and 2(g) are sectional views of the capacitor in the monitor element section.

As shown in FIGS. 2(a) and 2(b), an inter-layer insulating film 2 is formed on a P-type silicon substrate 1. Here, the inter-layer insulating film 2 is a silicon oxide film with thickness of about 500 nm deposited by a chemical vapor deposition (CVD) process. Then, capacitor contact holes 4 are formed in predetermined portions of the inter-layer dielectric film 2 on the memory section. Similarly, a capacitor contact hole 4a is formed in another predetermined portion on the monitor element section. Then, there are provided capacitor diffusion layers 3 and 3a.

Subsequently, a phosphorus doped amorphous silicon film 9 is formed over the entire semiconductor chip. Here, the phosphorus doped amorphous silicon film 9 has a thickness of about 500 nm. It is desirable that the phosphorus doped amorphous silicon film 9 is formed at a film formation temperature of 450 - 500°C by a reduced pressure CVD process using disilane (Si₂H₆) gas and phosphine (PH₃) gas as reaction gases.

Then, the phosphorus doped amorphous silicon film 9 is patterned to have predetermined dimensions by a photolithographic technology and a dry etching technology. This patterning forms an amorphous electrode 10 on the memory section in such a manner that it connects a capacitor diffusion layer 3, as shown in FIG. 2(c). Similarly, as shown in FIG. 2(d), a monitor amorphous electrode 11 is formed on the monitor element section.

Subsequently, as shown in FIG. 2(e), a laser beam 12 is irradiated only onto a region which becomes the lower electrode of the capacitor in the monitor element section, or only onto the surface of the monitor amorphous electrode 11 by using an appropriate mask (not shown). Here, an exima laser such as XeCl or KrF is used as the source of laser beam. Since such exima laser has its wavelength of 200 - 300 nm, irradiation of the laser beam crystallizes only the surface of the monitor amorphous electrode 11. This process completely prevents formation of the HSG-Si film on the surface of the monitor amorphous electrode 11, as described later. The laser irradiation may be performed before the lower electrode on the monitor element section is patterned.

The laser beam is not irradiated onto the amorphous electrodes 10 in the memory section. Thus, the amorphous electrodes 10 on the memory section remain an amorphous silicon film.

Then, natural oxidized films on the amorphous electrode 10 and the monitor amorphous electrode 11 are removed in diluted aqueous solution of hydrofluoric acid. Thereafter, silane gas is introduced onto the amorphous electrode 10 and the monitor amorphous electrode 11 in a vacuum apparatus. Subsequently, heat treatment is conducted at a temperature of about 550 - 600°C for about ten minutes. The heat treatment turns the surface of the amorphous silicon film to an HSG-Si film. Thus, the surface of the amorphous electrode 10 is turned into HSG-Si, and roughened. On the other hand, the surface of the monitor amorphous electrode 11 which is initially crystallized is not roughened.

As such, as shown in FIG. 2(f), the HSG type lower electrode 5 is formed on the memory section. On the other hand, the monitor lower electrode 8 keeps its surface smooth as shown in FIG. 2(g).

Then a silicon nitride film is deposited in a thickness of 5nm. Its surface is heat treated. As such, as described in conjunction with FIG. 1, the capacitive dielectric films 6 and 6a are formed on the surfaces of the lower electrode 5 and the monitor lower electrode 8, respectively, to form the upper electrode 7, whereby the semiconductor device of the present invention completes.

As described above, in the present invention, since only the surface of the monitor lower electrode is smoothed, it becomes possible to evaluate the film thickness of the capacitive dielectric film by measuring the capacity value of the capacitor. Then, it becomes possible to evaluate the increment of the surface area of the capacitor lower electrode on the memory section based on the evaluation on the film thickness.

Now, the second embodiment of the present invention will be explained with reference to FIG. 3. In this embodiment, an HSG type lower electrode and a lower electrode with smooth surface are formed as the lower electrodes of the capacitor formed in the monitor element section. FIG. 3 is a sectional view of the monitor element section.

As shown in FIG. 3, an inter-layer dielectric film 2 is formed on the surface of the silicon substrate 1. Capacitor diffusion layers 3 and 3a are selectively provided on the surface of the silicon substrate 1. In addition, capacitor contact holes are formed in predetermined regions of the inter-layer dielectric film 2, and one monitor lower electrode 8 as described in conjunction with the first embodiment is formed in a predetermined region of the inter-layer dielectric film 2. Here, the monitor lower electrode 8 does not have a roughened surface, but a smooth surface. Then, an HSG type monitor lower electrode 8a is formed. The monitor lower electrode 8a has the same shape as the lower electrode of the capacitor on the memory section.

In addition, a capacitive dielectric film 6a is formed on the monitor lower electrodes 8 and 8a. Furthermore, an upper electrode 7 is provided to coat the capacitive dielectric film 6a. Thus, two capacitors are formed on the monitor element section.

A manufacturing process for the semiconductor device according to the second embodiment is similar to that described for the first embodiment.

It should be noted that the same effect can be obtained by irradiating an electron beam instead of the laser beam described for the manufacturing process of the semiconductor device.

The above embodiments are described for a case where one or two capacitors is formed on the monitor element section in the same dimensions as the capacitor on the memory section. However, the present invention is not limited to such arrangement. The lower electrode of the capacitor formed on the monitor section may be formed to have dimensions larger than the lower electrode of the capacitor formed on the memory section. Alternatively, the capacitor on the monitor element section may be formed in a large number in the same dimensions as that of the capacitor on the memory section. The shape in this case is the same as that described for the above embodiments.

As described above, only the surface of the lower electrode of the capacitor on the monitor element section is smoothed in the semiconductor device with an HSG type capacitor.

With such arrangement, the film thickness of the capacitive dielectric film can be evaluated from the measurement and evaluation of the capacity value of the capacitor. Then, it becomes possible to separate the contribution of the surface area of the lower electrode from the contribution of the capacitive dielectric film in the capacity value of the capacitor. Thus, the increment of the surface area of the HSG type lower electrode can be easily evaluated only with the measurement and evaluation on the capacitor value of the capacitor.

This makes it easy to form the HSG type lower electrode or to monitor the capacitive dielectric film in the manufacturing process of a semiconductor device, whereby the reliability and manufacturing yield of the semiconductor device can be easily controlled. Such advantage of the present invention becomes significant when the semiconductor element is miniaturized so that the semiconductor device is highly integrated and densified.

Thus, the present invention can further promote very large scale integration and high densification of the semiconductor device such as a DRAM.

## Claims

1. A semiconductor device comprising a memory section and a monitor element section, said memory section including a plurality of memory cells each having a capacitor which has a storage electrode, said monitor element section including at least one capacitor which has a lower electrode, said storage electrode having a surface which is made uneven, and said lower electrode having a surface which is made smooth.

2. The semiconductor device as claimed in Claim 1, wherein said storage electrode is formed as a hemispherical silicon grain electrode.

3. The device as claimed in claim 1, said monitor element section further includes an additional capacitor, said additional capacitor having a lower electrode which has a surface that is made uneven.
